# EUROPEAN PATENT SPECIFICATION

(11) **EP 0 357 263 B1**
(45) Date of publication and mention of the grant of the patent: **28.07.1993**
(21) Application number: 89308096.0
(22) Date of filing: 09.08.1989
(51) Int. Cl.: C03C 17/245

(54) **Liquid coating composition and method for forming a fluorine-doped tin oxide coating on glass**
Flüssige Beschichtungszusammensetzung und Verfahren zur Herstellung von einer fluor-dotierten Zinnoxid-Beschichtung auf Glas
Composition de revêtement liquide et méthode pour former un revêtement d'oxyde d'étain dopé au fluor sur du verre

(30) Priority: 16.08.1988 US 232962
(43) Date of publication of application: 07.03.1990
(73) Proprietor: ATOCHEM NORTH AMERICA, INC., Philadelphia, Pennsylvania 19102 (US)
(72) Inventor: Gitlitz, Melvin H., Edison, N.J. 80820 (US); Russo, David A., Edison, N.J. 08820 (US)
(74) Representative: Stoner, Gerard Patrick

(56) References cited:
- EP-A- 0 186 481
- FR-A- 2 241 630

## Description

This invention relates to doped tin oxide coatings on glass, and more particularly, to a composition and method for forming fluorine-doped tin oxide coatings on glass, as well to coatings thus formed having improved electrical and haze properties.

Belanger et al in the J. Can. Cer. Soc. 52, 28-32 (1983), and the J. Electrochem. Soc. 32, 1398-1405 (1985), describes a method of forming Sb-doped tin oxide films on glass substrates by chemical vapor deposition of dibutyltin diacetate with antimony (V) chloride (SbCl₅) or trichlorotrifluoroethane (CCl₃-CF₃) as dopants in an oxidizing atmosphere using nitrogen as a carrier gas at substrate temperatures of 420-450°C. These Sb-doped films, however, have relatively high bulk resistivities of greater than 1 x 10⁻³ ohm-cm.

Abe, et al JP 61,188,821, issued Aug. 22, 1986, describes a method of preparing fluorine-doped tin oxide coatings using trifluoroacetic acid as the dopant in 25-65 wt. % of trichloroethane as a solvent. However, relatively poor bulk resistivities of 10⁻³ ohm-cm. are obtained.

Document EP-A-186481 is concerned with achieving a fluorine-doped tin oxide coating of low surface resistance. A coating composition is used comprising a chlorotin compound and a reactive organic fluorine dopant.

FR-A- 2241 630 is concerned with applying a tin-oxide coating to glass surfaces. Certain organotin compounds are used which are volatile below 200°C, and applying them to the substrate in an oxidizing atmosphere.

So, the problem addressed herein is to provide a new composition and method for making fluorine-doped tin oxide coatings on glass, which preferably have bulk resistivities of the order of 10⁻⁴ ohm-cm., and reduced haze.

One aspect of the solution given by the invention is to provide a liquid coating composition, comprising 50-80% by weight of a non- chloro organotin di- or tricarboxylate and 20-50% by weight of an organic fluoroacid, from which a fluorine-doped tin oxide coating of predetermined thickness having excellent bulk resistivities and haze values may be made by chemical vapor deposition onto glass substrates.

In a preferred version, the invention provides a liquid coating composition comprising dibutyltin diacetate and trifluoroacetic acid, from which a fluorine-doped tin oxide coating of about 2000 A (1Å = 10⁻⁸ cm), thickness can be made by chemical vapor deposition onto glass substrate having a bulk resistivity of about 10⁻⁴ ohm-cm.,a Gardner haze value of <1%, a visible transmittance of >80%, and an infrared reflectivity of >65%.

The liquid coating composition of the invention comprises 50-80% by wt. of an non- chloro organotin di- or tricarboxylate and about 20-50% by wt. of an organic fluoroacid. In the preferred form of the invention, the liquid coating composition includes about 50-60% by wt. of dibutyltin diacetate and about 40-50% by wt. of trifluoroacetic acid.

The method of the invention comprises vaporizing the liquid coating composition, transporting the vaporized coating composition in a carrier gas to a heated glass substrate, and contacting the glass with the vapor composition to deposit fluorine-doped tin oxide coatings on the glass. Such coatings of predetermined thickness have been found to have improved bulk resistivity and haze values.

Preferred organotin compounds of the liquid coating composition can be represented by the general formula:

R¹ₓSn(0₂CR¹¹)₄₋ₓ

where R¹ is a C₁ to C₄ straight or branched chain alkyl or R¹¹¹CH₂CH₂ - where R¹¹¹ is R^{1V}0₂C or CH₃CO and R^{IV} is C₁ to C₄ alkyl; R¹¹ is C₁ to C₄ straight or branched chain alkyl; and x is 1 or 2.

Illustrative non-limiting examples of organotin compounds suitable for use herein are: dibutyltin diacetate, butyltin triacetate, methyltin triacetate, dimethyltin diacetate, dibutyltin dipropionate, dimethyltin dipropionate, methyltin tripropionate, diisobutyltin diacetate, bis(carbomethoxyethyl)tin diacetate, and bis(3-oxobutyl)tin diacetate.

The organofluoroacid dopants suitable for use in this invention are reactive fluorine compounds which are strong acids or compounds which have boiling points below 250°C. Anhydrides are included.

Illustrative non-limiting examples of dopants suitable for use are: trifluoroacetic acid, difluoroacetic acid, perfluoropropionic acid, chlorodifluoroacetic acid, trifluoroacetic anhydride and perfluoropropionic anhydride. The preferred dopant is trifluoroacetic acid.

The liquid coating compositions suitably contain about 50-80% by wt. of a liquid or low-melting organotin carboxylate and about 20-50% by wt. of the fluorine dopant, which is either soluble in the organotin, capable of being solubilized by a third agent, or capable of being vaporized separately from the organotin compound. The preferred liquid coating compositions comprise about 50-60% of the organotin compound and about 40-50% by wt. of the fluorine dopant.

The fluorine-doped tin oxide coatings are deposited by chemical vapor deposition, preferably from a vaporized liquid coating composition; the compounds also can be vaporized separately in a heated chamber from about 100-300°C, preferably from 130-200°C.

A preheated carrier gas transports the vapor to a nozzle which disperses the vapors uniformly over a substrate, usually glass, heated to a temperature of about 450-750°C, preferably 600-700°C. The carrier gas may be air, oxygen, or nitrogen and its temperature can range from 100-300°C, preferably from 130-200°C. The flow rate of the carrier gas can range from 1-100 liter/min, preferably 25-75 liters/min, and its velocity can range from 0.25-5 m/sec, preferably from 0.5-3 m/sec. The concentration of the precursor in the carrier gas can range from about 0.1 to 10 mol%, preferably from about 0.1-2 mol%.

Using the compositions and methods described it has been found possible to prepare fluorine-doped tin oxide coatings having bulk resistivities <9 x 10⁻⁴ ohm-cm., haze values of <1% (Gardner Hazemeter), a visible transmittance of 80% or more, and an infrared reflectivity of >65%, for a coating thickness of 2000 Å (2·10⁻⁵ cm)

Embodiments of the invention are now described by way of example.

### EXAMPLE 1

a.) A liquid coating composition of 60 wt.% dibutyltin diacetate (DBTA) and 40 wt% trifluoroacetic acid (TFA) was injected via a syringe pump into a 170°C. air stream flowing at 70 liters/min. The concentration of the vaporized solution in air was 0.25 mol%. The vapor was transported to a soda lime silica glass substrate maintained at a temperature of 600°C. A transparent, conductive fluorine-doped tin oxide coating of about 1,92·10⁻⁵ cm (1920 Å) was deposited. The bulk resistivity was 6.3 x 10⁻⁴ ohm-cm. and the Gardner haze value was less then 1%. The sheet resistance of the film was 33 ohms/sq., as measured by a four-point probe.
b.) The effect on bulk resistivity of varying the concentration of trifluoroacetic acid in the liquid coating composition is shown in the following Table.

**Table**

| Effect of Conc. of Trifluoroacetic Acid on Bulk Resistivity of Films | |
|---|---|
| Liquid Coating Composition (Wt%) DBTA/TFA | F-Doped Tin Oxide Film Bulk Resistivity ( x 10⁻⁴ ohm-cm) |
| 50/50 | 6.3 |
| 60/40 | 6.3 |
| 70/30 | 7.1 |
| 80/20 | 8.1 |
| 85/15 | 9.4 |
| 90/10 | 12.4 |
| 95/5 | 19.2 |

The results in the Table shown that the desired low bulk resistivities of 10⁻⁴ ohm-cm are achieved with a DBTA/TFA ratio of about 50:50 wt.%; relatively low TFA compositions, on the other hand, produce fluorine-doped tin oxide coatings having much poorer bulk resistivity values.

The preferred liquid coating compositions of the invention provide coatings which have low bulk resistivities and low haze values, at a relatively high tin content. These parameters are achieved herein preferably by using about 50-60% by wt. of DBTA and about 40-50% wt. of TFA.

The improved coatings obtained as described are made by chemical vapor deposition in the substantial absence of any solvent for the components of the composition., e.g. less than 10% by wt. of the composition.

## Claims (Claims for the following Contracting State(s): AT, BE, CH, LI, DE, FR, GB, GR, IT, LU, NL, SE)

1. A liquid coating composition comprising 50-80% by weight of a non-Chloro organotin di- or tricarboxylate and 20-50% by wt. of an organic fluoroacid.

2. A liquid coating composition according to claim 1 comprising 50-60% by wt. of said organotin di-or tricarboxylate, and 40-50% by wt. of said fluoroacid.

3. A liquid coating composition according to claim 1 or claim 2 wherein said organotin di-or tricarboxylate is of the formula
R¹ₓSn(0₂CR¹¹)₄₋ₓ
where R¹ is a C₁ to C₄ straight or branched chain alkyl or R¹¹¹CH₂CH₂ - where R¹¹¹ is R^{1V}0₂c or CH₃CO and R^{IV} is C₁ to C₄ alkyl; R¹¹ is C₁ to C₄ straight or branched chain alkyl; and x is 1 or 2.

4. A liquid coating composition according to any one of claims 1 to 3, wherein said fluoroacid is selected from trifluoroacetic acid, difluoroacetic acid, perfluoropropionic acid, chlorodifluoracetic acid, trifluoroacetic anhydride and perfluoropropionic anhydride.

5. A liquid coating composition according to any one of the preceding claims wherein said organotin di- or tricarboxylate is selected from dibutyltin diacetate, butyltin triacetate, methyltin triacetate, dimethyltin diacetate, dibutyltin dipropionate, dimethyltin dipropionate, methyltin tripropionate, diisobutyltin diacetate, bis(carbomethoxyethyl)tin diacetate, and bis(3-oxobutyl)tin diacetate.

6. A liquid coating composition according to any one of the preceding claims wherein said organotin di- or tricarboxylate is dibutyltin diacetate and said organic fluoroacid is trifluoroacetic acid.

7. A liquid coating composition according to claim 1 comprising about 60% by wt. dibutyltin diacetate and about 40% by wt. trifluoroacetic acid.

8. A liquid coating composition according to any one of the preceding claims, substantially solvent-free.

9. A method of forming a fluorine-doped tin oxide coating on glass, comprising applying a vaporised non-chloro organotin di- or tri-carboxylate and a vaporised organic fluoroacid to the heated glass surface, at 50-80 wt% organotin compound to 20 - 50 wt% fluoroacid.

10. A method according to claim 9, comprising vaporizing a composition according to any one of claims 1 to 8.

11. A method according to claim 9 wherein the organotin compound and fluoroacid are vaporised separately from one another.

12. A method according to any one of claims 9 to 11 wherein the glass surface is at a temperature of from 450-750°C.

13. A fluorine-doped tin oxide coating on glass, obtainable by a method according to any one of claims 9 to 12.

14. A coating according to claim 13, having a bulk resistivity of 9 x 10⁻⁴ ohm.cm or less and a Gardner haze value less than 1%.

## Claims (Claims for the following Contracting State(s): ES)

1. A method of making a liquid composition for coating glass, comprising mixing 50 to 80% by weight of a non-chloro organotin di- or tricarboxylate and 20 to 50% by weight of an organic fluoroacid.

2. A method according to claim 1, in which 50 to 60% by weight of the organotin di- or tricarboxylate are mixed, and about 40 to 50% by weight of the fluoroacid.

3. A method according to claim 1 or claim 2 in which the organotin di- or tricarboxylate is of the formula
R¹ₓSn(0₂CR¹¹)₄₋ₓ
where R¹ is a C₁ to C₄ straight or branched chain alkyl or R¹¹¹CH₂CH₂ - where R¹¹¹ is R^{1V}0₂C or CH₃CO and R^{IV} is C₁ to c₄ alkyl; R¹¹ is C₁ to C₄ straight or branched chain alkyl; and x is 1 or 2.

4. A method according to any one of claims 1 to 3, wherein said fluoroacid is selected from trifluoroacetic acid, difluoroacetic acid, perfluoropropionic acid, chlorodifluoroacetic acid, trifluoroacetic anhydride and perfluoropropionic anhydride.

5. A method according to any one of the preceding claims wherein said organotin di- or tricarboxylate is selected from dibutyltin diacetate, butyltin triacetate, methyltin triacetate, dimethyltin diacetate, dibutyltin dipropionate, dimethyltin dipropionate, methyltin tripropionate, diisobutyltin diacetate, bis(carbomethoxyethyl)tin diacetate, and bis(3-oxobutyl)tin diacetate.

6. A method according to any one of the preceding claims wherein the said organotin di- or tricarboxylate is dibutyltin diacetate and said organic fluoroacid is trifluoroacetic acid.

7. A method according to claim 1, comprising mixing about 60% by weight dibutyltin diacetate and about 40% trifluoroacetic acid.

8. A method according to any one of the preceding claims, in which a solvent is not mixed in the composition.

9. A method of forming a fluorine-doped tin oxide coating on glass, comprising applying a vaporised non-chloro organotin di- or tricarboxylate and a vaporised organic fluoroacid to the heated glass surface, at 50-80wt% organotin compound to 20-50wt% fluoroacid.

10. A method according to claim 9, comprising vaporising a composition formed in accordance with any one of claims 1 to 8.

11. A method according to claim 9 wherein the organotin compound and fluoroacid are vaporised separately from one another.

12. A method according to any one of claims 9 to 11 wherein the glass surface is at a temperature of from 450-750°C.

13. A fluorine-doped tin oxide coating on glass, obtainable by a method according to any one of claims 9 to 12.

14. A coating according to claim 13, having a bulk resistivity of 9 x 10⁻⁴ ohm.cm or less and a Gardner haze value less than 1%.

## Patentansprüche (Patentansprüche für folgende(n) Vertragsstaat(en): AT, BE, CH, LI, DE, FR, GB, GR, IT, LU, NL, SE)

1. Flüssige Beschichtungsmasse, dadurch **gekennzeichnet,** daß sie 50-80 Gew.-% eines chlorfreien Organozinndi- oder -tricarboxylats und 20-50 Gew.-% einer Fluor enthaltenden organischen Säure enthält.

2. Flüssige Beschichtungsmasse nach Anspruch 1, dadurch **gekennzeichnet,** daß sie 50-60 Gew.-% des genannten Organozinndi- oder -tricarboxylats und 40-50 Gew.-% der genannten Fluor enthaltenden Säure enthält.

3. Flüssige Beschichtungsmasse nach Anspruch 1 oder 2, dadurch **gekennzeichnet,** daß das genannte Organozinndi- oder -tricarboxylat die Formel
R¹ₓSn(O₂CR¹¹)₄₋ₓ
aufweist, in der R¹ eine geradkettige oder versweigtkettige C₁-C₄-Alkylgruppe ist, oder R¹¹¹CH₂CH₂ ist - wobei R¹¹¹ gleich R^{1V}O₂C oder CH₃CO ist, und R^{IV} eine C₁-C₄-Alkylgruppe ist; R¹¹ eine geradkettige oder verzweigtkettige C₁-C₄-Alkylgruppe ist; und x gleich 1 oder 2 ist.

4. Flüssige Beschichtungsmasse nach einem der Ansprüche 1 bis 3, dadurch **gekennzeichnet,** daß die genannte Fluor enthaltende Säure aus Trifluoressigsäure, Difluoressigsäure, Perfluorpropionsäure, Chlordifluoressigsäure, Trifluoressigsäureanhydrid und Perfluorpropionsäureanhydrid ausgewählt ist.

5. Flüssige Beschichtungsmasse nach einem der vorhergehenden Ansprüche, dadurch **gekennzeichnet,** daß das genannte Organozinndi- oder -tricarboxylat aus Dibutylzinndiacetat, Butylzinntriacetat, Methylzinntriacetat, Dimethylzinndiacetat, Dibutylzinndipropionat, Dimethylzinndipropionat, Methylzinntripropionat, Diisobutylzinndiacetat, Bis(carbmethoxyethyl)zinndiacetat und Bis(3-Oxobutyl)zinndiacetat ausgewählt ist.

6. Flüssige Beschichtungsmasse nach einem der vorhergehenden Ansprüche, dadurch **gekennzeichnet,** daß das genannte Organosinndi- oder -tricarboxylat Dibutylzinndiacetat ist und die genannte Fluor enthaltende organische Säure Trifluoressigsäure ist.

7. Flüssige Beschichtungsmasse nach Anspruch 1, dadurch **gekennzeichnet,** daß sie etwa 60 Gew.-% Dibutylzinndiacetat und etwa 40 Gew.-% Trifluoressigsäure enthält.

8. Flüssige Beschichtungsmasse nach einem der vorhergehenden Ansprüche, dadurch **gekennzeichnet,** daß sie im wesentlichen lösungsmittelfrei ist.

9. Verfahren zur Bildung eines Fluor-dotierten Zinnoxidüberzugs auf Glas, dadurch **gekennzeichnet,** daß man ein verdampftes, chlorfreies Organozinndi- oder -tricarboxylat und eine verdampfte, Fluor enthaltende organische Säure in einem Verhältnis von 50-80 Gew.-% der Organozinnverbindung zu 20-50 Gew.-% der Fluor enthaltenden Säure auf die erhitzte Glasoberfläche aufbringt.

10. Verfahren nach Anspruch 9, dadurch **gekennzeichnet,** daß man eine Masse nach einem der Ansprüche 1 bis 8 aufdampft.

11. Verfahren nach Anspruch 9, dadurch **gekennzeichnet,** daß man die Organozinn-Verbindung und die Fluor enthaltende Säure getrennt voneinander aufdampft.

12. Verfahren nach einem der Ansprüche 9 bis 11, dadurch **gekennzeichnet,** daß die Glasoberfläche eine Temperatur von 450-750°C besitzt.

13. Fluor-dotierter Zinnoxidüberzug auf Glas, erhältlich durch ein Verfahren nach einem der Ansprüche 9 bis 12.

14. Überzug nach Anspruch 13, dadurch **gekennzeichnet,** daß sie einen spezifischen Innenwiderstand von 9 x 10⁻⁴ Ohm.cm oder weniger und einen Gardner-Trübungswert von weniger als 1 % hat.

## Patentansprüche (Patentansprüche für folgende(n) Vertragsstaat(en): ES)

1. Verfahren zur Herstellung einer flüssigen Masse zur Beschichtung von Glas, dadurch **gekennzeichnet,** daß man 50 bis 80 Gew.-% eines chlorfreien Organozinndi- oder -tricarboxylats und 20 bis 50 Gew.-% einer Fluor enthaltenden organischen Säure mischt.

2. Verfahren nach Anspruch 1, dadurch **gekennzeichnet,** daß man 50 bis 60 Gew.-% des Organozinndi- oder -tricarboxylats und etwa 40 bis 50 Gew.-% der Fluor enthaltenden Säure mischt.

3. Verfahren nach Anspruch 1 oder Anspruch 2, dadurch **gekennzeichnet,** daß das Organozinndi- oder -tricarboxylat die Formel
R¹ₓSn(O₂CR¹¹)₄₋ₓ
aufweist, in der R¹ eine geradkettige oder verzweigtkettige C₁-C₄-Alkylgruppe oder R¹¹¹CH₂CH₂ ist - wobei R¹¹¹ gleich R^{1V}O₂C oder CH₃CO ist, und R^{IV} eine C₁-C₄-Alkylgruppe ist; R¹¹ eine geradkettige oder verzweigtkettige C₁-C₄-Alkylgruppe ist; und x gleich 1 oder 2 ist.

4. Verfahren nach einem der Ansprüche 1 bis 3, dadurch **gekennzeichnet,** daß die genannte Fluor enthaltende Säure aus Trifluoressigsäure, Difluoressigsäure, Perfluorpropionsäure, Chlordifluoressigsäure, Trifluoressigsäureanhydrid und Perfluorpropionsäureanhydrid ausgewählt ist.

5. Verfahren nach einem der vorhergehenden Ansprüche, dadurch **gekennzeichnet,** daß das genannte Organozinndi- oder -tricarboxylat aus Dibutylzinndiacetat, Butylzinntriacetat, Methylzinntriacetat, Dimethylzinndiacetat, Dibutylzinndipropionat, Dimethylzinndipropionat, Methylzinntripropionat, Diisobutylzinndiacetat, Bis(carbmethoxyethyl)zinndiacetat und Bis(3-Oxobutyl)zinndiacetat ausgewählt ist.

6. Verfahren nach einem der vorhergehenden Ansprüche, dadurch **gekennzeichnet,** daß das genannte Organozinndi- oder -tricarboxylat Dibutylzinndiacetat ist und die genannte Fluor enthaltende organische Säure Trifluoressigsäure ist.

7. Verfahren nach Anspruch 1, dadurch **gekennzeichnet,** daß man etwa 60 Gew.-% Dibutylzinndiacetat und etwa 40 Gew.-% Trifluoressigsäure mischt.

8. Verfahren nach einem der vorhergehenden Ansprüche, dadurch **gekennzeichnet,** daß der Masse kein Lösungsmittel beigemischt wird.

9. Verfahren zur Bildung eines Fluor-dotierten Zinnoxidüberzugs auf Glas, dadurch **gekennzeichnet,** daß man ein verdampftes, chlorfreies Organozinndi- oder -tricarboxylat und eine verdampfte, Fluor enthaltende organische Säure in einem Verhältnis von 50-80 Gew.-% der Organozinnverbindung zu 20-50 Gew.-% der Fluor enthaltenden Säure auf die erhitzte Glasoberfläche aufbringt.

10. Verfahren nach Anspruch 9, dadurch **gekennzeichnet,** daß man eine einem der Ansprüche 1 bis 8 entsprechende Masse aufdampft.

11. Verfahren nach Anspruch 9, dadurch **gekennzeichnet,** daß man die Organozinn-Verbindung und die Fluor enthaltende Säure getrennt voneinander aufdampft.

12. Verfahren nach einem der Ansprüche 9 bis 11, dadurch **gekennzeichnet,** daß die Glasoberfläche eine Temperatur von 450-750°C besitzt.

13. Fluor-dotierter Zinnoxidüberzug auf Glas, erhältlich durch ein Verfahren nach einem der Ansprüche 9 bis 12.

14. Überzug nach Anspruch 13, dadurch **gekennzeichnet,** daß sie einen spezifischen Innenwiderstand von 9 X 10⁻⁴ Ohm.cm oder weniger und einen Gardner-Trübungswert von weniger als 1 % hat.

## Revendications (Revendications pour l'(les) Etat(s) contractant(s) suivant(s): AT, BE, CH, LI, DE, FR, GB, GR, IT, LU, NL, SE)

1. Composition liquide de revêtement, comprenant 50 à 80 % en poids d'un dicarboxylate ou tricarboxylate organique d'étain non chloré et 20 à 50 % en poids d'un acide fluoré organique.

2. Composition liquide de revêtement suivant la revendication 1, comprenant 50 à 60 % en poids du dicarboxylate ou tricarboxylate organique d'étain en question et 40 à 50 % en poids de l'acide fluoré en question.

3. Composition liquide de revêtement suivant la revendication 1 ou la revendication 2, dans laquelle le dicarboxylate ou tricarboxylate organique d'étain répond à la formule
R¹ₓSn(O₂CR¹¹)₄₋ₓ
dans laquelle R¹ est un groupe alkyle à chaîne droite ou ramifiée en C₁ à C₄ ou un groupe R¹¹¹CH₂CH₂ - où R¹¹¹ est un groupe R^{IV}O₂C ou CH₃CO et R^{IV} est un groupe alkyle en C₁ à C₄ ; R¹¹ est un groupe alkyle à chaîne droite ou ramifiée en C₁ à C₄ ; et x a la valeur 1 ou 2.

4. Composition liquide de revêtement suivant l'une quelconque des revendications 1 à 3, dans laquelle l'acide fluoré est choisi entre l'acide trifluoracétique, l'acide difluoracétique, l'acide perfluoropropionique, l'acide chlorodifluoracétique, l'anhydride trifluoracétique et l'anhydride perfluoropropionique.

5. Composition liquide de revêtement suivant l'une quelconque des revendications précédentes, dans laquelle le dicarboxylate ou tricarboxylate organique d'étain est choisi entre le diacétate de dibutylétain, le triacétate de butylétain, le triacétate de méthylétain, le diacétate de diméthylétain, le dipropionate de dibutylétain, le dipropionate de diméthylétain, le tripropionate de méthylétain, le diacétate de diisobutylétain, le diacétate de bis(carbométhoxyéthyl)étain et le diacétate de bis(3-oxobutyl)étain.

6. Composition liquide de revêtement suivant l'une quelconque des revendications précédentes, dans laquelle le dicarboxylate ou tricarboxylate organique d'étain est le diacétate de dibutylétain et l'acide organique fluoré est l'acide trifluoracétique.

7. Composition liquide de revêtement suivant la revendication 1, comprenant environ 60 % en poids de diacétate de dibutylétain et environ 40 % en poids d'acide trifluoracétique.

8. Composition liquide de revêtement suivant l'une quelconque des revendications précédentes, principalement dépourvue de solvant.

9. Procédé pour former sur du verre un revêtement d'oxyde détain dopé au fluor, comprenant l'application d'un dicarboxylate ou tricarboxylate organique d'étain non chloré vaporisé et d'un acide organique fluoré vaporisé à la surface du verre chauffé, en proportion de 50 à 80 % en poids de composé organique d'étain pour 20 à 50 % en poids d'acide fluoré.

10. Procédé suivant la revendication 9, comprenant la vaporisation d'une composition suivant l'une quelconque des revendications 1 à 8.

11. Procédé suivant la revendication 9, dans lequel le composé organique d'étain et l'acide fluoré sont vaporisés séparément l'un de l'autre.

12. Procédé suivant l'une quelconque des revendications 9 à 11, dans lequel la surface du verre se trouve à une température de 450 à 750°C.

13. Revêtement d'oxyde détain dopé au fluor sur du verre, pouvant être obtenu par un procédé suivant l'une quelconque des revendications 9 à 12.

14. Revêtement suivant la revendication 13, ayant une résistivité volumique de 9 x 10⁻⁴ ohm.cm ou moins et une valeur de voile Gardner de moins de 1 %.

## Revendications (Revendications pour l'(les) Etat(s) contractant(s) suivant(s): ES)

1. Procédé de production d'une composition liquide pour le revêtement de verre, comprenant le mélange de 50 à 80 % en poids d'un dicarboxylate ou tricarboxylate organique d'étain non chloré et de 20 à 50 % en poids d'un acide fluoré organique.

2. Procédé suivant la revendication 1, dans lequel sont mélangés 50 à 60 % en poids du dicarboxylate ou tricarboxylate organique d'étain et environ 40 à 50 % en poids de l'acide fluoré.

3. Procédé suivant la revendication 1 ou la revendication 2, dans lequel le dicarboxylate ou tricarboxylate organique d'étain répond à la formule
R¹ₓSn(O₂CR¹¹)₄₋ₓ
dans laquelle R¹ est un groupe alkyle à chaîne droite ou ramifiée en C₁ à C₄ ou un groupe R¹¹¹CH₂CH₂ - où R¹¹¹ est un groupe R^{IV}O₂C ou CH₃CO et R^{IV} est un groupe alkyle en C₁ à C₄ ; R¹¹ est un groupe alkyle à chaîne droite ou ramifiée en C₁ à C₄ ; et x a la valeur 1 ou 2.

4. Procédé suivant l'une quelconque des revendications 1 à 3, dans lequel l'acide fluoré est choisi entre l'acide trifluoracétique, l'acide difluoracétique, l'acide perfluoropropionique, l'acide chlorodifluoracétique, l'anhydride trifluoracétique et l'anhydride perfluoropropionique.

5. Procédé suivant l'une quelconque des revendications précédentes, dans lequel le dicarboxylate ou tricarboxylate organique d'étain est choisi, entre le diacétate de dibutylétain, le triacétate de butylétain, le triacétate de méthylétain, le diacétate de diméthylétain, le dipropionate de dibutylétain, le dipropionate de diméthylétain, le tripropionate de méthylétain, le diacétate de diisobutylétain, le diacétate de bis(carbométhoxyéthyl)étain et le diacétate de bis(3-oxobutyl)étain.

6. Procédé suivant l'une quelconque des revendications précédentes, dans lequel le dicarboxylate ou tricarboxylate organique d'étain est le diacétate de dibutylétain et l'acide organique fluoré est l'acide trifluoracétique.

7. Procédé suivant la revendication 1, comprenant le mélange d'environ 60 % en poids de diacétate de dibutylétain et d'environ 40 % en poids d'acide trifluoracétique.

8. Procédé suivant l'une quelconque des revendications précédentes, dans lequel le solvant n'est pas mélangé dans la composition.

9. Procédé pour former sur du verre un revêtement d'oxyde détain dopé au fluor, comprenant l'application d'un dicarboxylate ou tricarboxylate organique d'étain non chloré vaporisé et d'un acide organique fluoré vaporisé à la surface du verre chauffé, en proportion de 50 à 90 % en poids de composé organique d'étain pour 20 à 50 % en poids d'acide fluoré.

10. Procédé suivant la revendication 9, comprenant la vaporisation d'une composition obtenue conformément à l'une quelconque des revendications 1 à 8.

11. Procédé suivant la revendication 9, dans lequel le composé organique d'étain et l'acide fluoré sont vaporisés séparément l'un de l'autre.

12. Procédé suivant l'une quelconque des revendications 9 à 11, dans lequel la surface du verre se trouve à une température de 450 à 750°C.

13. Revêtement d'oxyde détain dopé au fluor sur du verre, pouvant être obtenu par un procédé suivant l'une quelconque des revendications 9 à 12.

14. Revêtement suivant la revendication 13, ayant une résistivité volumique de 9 x 10⁻⁴ ohm.cm ou moins et une valeur de voile Gardner inférieure à 1 %.
